# DEMANDE DE BREVET EUROPEEN

(11) **EP 0 536 026 A1**
(43) Date de publication de la demande: **07.04.1993**
(21) Numéro de dépôt: 92402634.7
(22) Date de dépôt: 25.09.1992
(51) Int. Cl.: G11C 29/00

(54) **Procédé de test de mémoire multiport**

(30) Priorité: 04.10.1991 FR 9112225
(71) Demandeur: THOMSON COMPOSANTS MILITAIRES ET SPATIAUX, F-92402 Courbevoie (FR)
(72) Inventeur: Lestrat, Patrick, F-92045 Paris La Défense (FR); Castro-Alves, Vladimir, F-92045 Paris La Défense (FR)
(74) Mandataire: Guérin, Michel

(57) **Abrégé**

Il est décrit un algorithme de test permettant de détecter des défauts spécifiques des mémoires multiports, c'est-à-dire des mémoires qu'on peut adresser indépendamment par plusieurs ports. Cet algorithme utilise des opérations d'écriture simultanée par plusieurs ports de la mémoire et permet de détecter des défauts de couplage complexe dans lesquels l'état d'une cellule cⱼ de mémoire est perturbé par une transition d'état simultanée de deux cellules voisines ci et cₖ.L'algorithme comporte, pour une mémoire biport, deux groupes de quatre séquences de test (S1,S2,S3,S4; S'1, S'2, S'3, S'4). Cahque séquence comporte un groupe de plusieurs opérations de lecture (Rₒₒ, R₁₁) et d'écriture (Dₒₒ, D₁₁, D10, D₀₁) effectuées sur des couples de cellules. Les couples de cellules traités dans chaque séquence se succèdent dans un ordre déterminé ; l'ordre inverse est utilisé pour certaines des séquences.

## Description

### INTRODUCTION : MEMOIRES MULTIPORTS

L'invention concerne le test des mémoires multiport.

Une mémoire multiport est une mémoire comportant un ensemble de mots d'information auxquels on peut accéder de manière indépendante par plusieurs ports d'entrée-sortie; le terme multiport les distingue donc des mémoires les plus courantes qui n'ont qu'un port d'entrée-sortie, c'est-à-dire qui n'ont qu'un décodeur d'adresse pour donner une adresse de mot à lire ou à écrire et qu'un bus de données pour lire ou écrire le mot.

Dans le cas le plus simple des mémoires multiports, on trouve évidemment les mémoires bi-portqui ont deux accès indépendants vers les mots de la mémoire. Elles ont alors deux décodeurs qui fournissent deux adresses de mots différentes, et deux bus de données pour écrire ou lire les mots.

Dans la pratique, selon l'usage qu'on veut en faire, les deux ports ne fonctionnent pas nécessairement à la fois en lecture et en écriture. On peut avoir par exemple un port capable de lire seulement mais pas d'écrire, et l'autre capable de lire et d'écrire; ou même un port capable de lire seulement et l'autre capable d'écrire seulement. Dans le cas où les deux ports sont capables d'écrire, on doit cependant prévoir une logique de détection de conflits pour interdire l'écriture simultanée d'informations contradictoires à la même adresse.

Pour réaliser une mémoire multiport de n ports dans le cas général, on devra multiplier par n toutes les lignes de bit et les lignes de mot, ainsi que les décodeurs et les amplificateurs de lecture et d'écriture; seules les cellules de stockage d'information proprement dites ne sont pas multipliées.

Le plus souvent, les mémoires multiports sont des mémoires RAM statiques; mais on pourrait aussi envisager d'autres types de mémoire, selon les besoins.

On utilise ces mémoires pour réaliser des échanges d'informations rapides entre deux systèmes non synchronisés, par exemple de type "boîte aux lettres" : un système écrit des informations dans la mémoire; l'autre peut aller chercher des informations dans la même mémoire de manière indépendante; et réciproquement. Avec plus de deux ports d'entrée- sortie, on peut réaliser des réseaux avec un système serveur qui écrit dans la mémoire et plusieurs systèmes esclaves qui peuvent lire indépendamment ce qu'a écrit le serveur.

Bien entendu, une mémoire multiport peut être organisée en N lignes de M mots de P bits comme les mémoires à un seul port ; en outre, il y a le plus souvent un entrelaçage classique de mots, c'est-à-dire que deux cellules de mémoire voisines en ligne correspondent à deux mots différents (le plus souvent, les bits de même rang des différents mots sont tous juxtaposés, d'ailleurs pas forcément dans l'ordre logique d'adressage des mots de la ligne). Le port comprend alors P plots de données et P multiplexeurs (1 parmi M) pour relier les colonnes de cellules du plan mémoire aux P plots de données. Les multiplexeurs sont commandés par un décodeur de colonne permettant de sélectionner un mot parmi M mots d'une ligne; c'est ce décodeur de colonne qui définit la relation entre l'ordre logique des mots et l'ordre physique des colonnes. Les lignes sont évidemment sélectionnées par un décodeur de ligne (1 ligne parmi N).

Les informations qui précèdent ne sont données qu'à titre de rappel, les mémoires multiports étant maintenant bien connues et de plus en plus utilisées.

### TEST DES MEMOIRES

Le problème plus spécifique auquel s'intéresse la présente invention est celui du test de ces mémoires.

On sait en effet que le test des mémoires est un facteur de coût de plus en plus important au fur et à mesure que les capacités de stockage des mémoires augmentent. Et l'utilisation de mémoires multiports n'est pas faite pour simplifier le problème.

Le test pose d'ailleurs encore plus de problèmes lorsque les mémoires sont intégrées dans des circuits intégrés qui comprennent d'autres éléments que la mémoire elle-même.

Aujourd'hui, les mémoires sont testées soient par un testeur complètement extérieur, soit en complétant le testeur extérieur par un circuit auxiliaire interne au circuit intégré ("Built-In-Self-Test").

Des algorithmes de test ont été mis au point pour détecter divers types de défauts pouvant affecter le fonctionnement des mémoires simple port.

Par algorithme de test, on entend une succession d'opérations physiques d'écriture et lecture de cellules, qui sont exécutées dans un ordre déterminé et qui peuvent être répétées par itérations successives jusqu'à ce que l'ensemble de la mémoire ait subi le test.

En pratique, aujourd'hui, les algorithmes de test comportent une succession d'opérations faites en se référant à une cellule de base, et l'ensemble du test consiste à réitérer les opérations en changeant à chaque fois de cellule de base, jusqu'à ce que toutes les cellules de la mémoire aient été utilisées en tant que cellules de base. Souvent, l'algorithme est décomposé en plusieurs séquences, et dans ce cas chaque séquence est effectuée avec successivement toutes les cellules de la mémoire comme cellules de base.

La qualité d'un algorithme de test réside dans sa rapidité, et dans son taux de couverture de défauts, c'est-à-dire son aptitude à détecter tous les défauts possibles.

Les algorithmes existants servent à détecter essentiellement les fautes de collage, c'est-à-dire l'impossibilité de faire changer une cellule d'état, et les fautes de couplage entre cellules, c'est-à-dire la perturbation du fonctionnement d'une cellule sous l'effet de l'écriture d'une autre cellule.

Par exemple, l'article de D.S. SUK et S.M. RED-DY dans IEEE Transactions on Computers vol. C-30 N° 12, Décembre 1981 "A march test for functional faults in semiconductor random access memories" décrit un tel algorithme. La conférence de M. MARI-NESCU à IEEE International Test Conference 1982 "Simple and efficient algorithms for functional RAM testing" décrit d'autres algorithmes. Ces algorithmes portent sur des mémoires simple port.

Des travaux ont été faits pour adapter ces types d'algorithmes à des mémoires multiports : M.J. RA-POSA International Test Conference 1988 "Dual-port static RAM testing"; ou B. NADEAU-DOSTIE, A. SIL-BURT, V.K. AGARWAL, IEEE Design & Test of Computers Avril 1990 "Serial Interfacing for Embed- ded-Memory Testing". Ils consistent pratiquement en une simple transposition des algorithmes précédents.

### RESUME DE L'INVENTION

Selon l'invention, on s'est aperçu que les algorithmes de l'art antérieur risquaient de ne pas détecter certains défauts de couplage dans les mémoires multiports.

Selon un aspect général de l'invention, on propose d'utiliser pour le test des mémoires multiports un algorithme de test qui comporte des opérations d'écriture simultanée dans deux cellules Ci et cₖ par deux ports de la mémoire, pour détecter des défauts de couplage qui perturbent le fonctionnement d'une cellule _{Cj} lors de l'accès simultané à une cellule Ci par un des ports et à une cellule cₖ par un autre port, même lorsque la cellule _{Cj} n'est pas perturbée par un accès individuel à la cellule cᵢ ou la cellule cₖ.

Ce type de défaut de couplage peut résulter de couplages capacitifs entre les trois cellules voisines ou de fuites résistives entre ces cellules, surtout lorsqu'elles sont voisines; ces couplages ou fuites peuvent très bien être intrinsèquement assez faibles pour ne pas entraîner de défauts, mais assez forts pour s'additionner (si leurs influences sont de même sens) et entraîner un défaut s'ils apparaissent simultanément.

Dans la suite, on appellera "défauts de couplage complexes" ces défauts, par opposition aux défauts de couplage simple qui sont classiquement détectés par les algorithmes de test existants et qui représentent des perturbations d'une cellule sous l'influence simple d'une transition d'état d'une autre cellule.

Plus généralement encore, l'invention n'est pas limitée aux mémoires bi-port, et elle propose, pour une mémoire multiport, d'utiliser un algorithme de test qui comporte des opérations d'écriture simultanée dans plusieurs cellules de mémoire par les différents ports de la mémoire, pour détecter des défauts de couplage complexe qui perturbent le fonctionnement d'une cellule _{Cj} de la mémoire lors de transitions simultanées de cellules adressées chacune par un port respectif, alors que des transitions non simultanées peuvent ne pas entraîner pas de défaut.

La structure préférée de l'algorithme de test, pour une mémoire à k ports (k>1) est une structure à 2k-groupes de quatre séquences de test; chaque groupe est affecté à la détection de défauts engendrés par une configuration déterminée de k transitions simultanées et par la configuration complémentaire de k transitions simultanées inverses des premières; chacune des quatre séquences du groupe comporte à cet effet des opérations d'écriture simultanée correspondant à cette configuration et à la configuration complémentaire, toutes les configurations de transitions dont on veut détecter les effets étant représentées dans les 2k- groupes et une seule de ces configurations étant utilisée, avec la configuration complémentaire, dans chaque groupe de quatre séquences; les opérations d'écriture sont effectuées à chaque fois sur un ensemble déterminé de k cellules et chaque séquence comporte des opérations sensiblement identiques effectuées sur une succession déterminée d'ensembles de k cellules.

De préférence, parmi les quatre séquences d'un groupe de séquences, il y en a deux qui sont effectuées sur cette succession d'ensembles de k cellules dans un ordre déterminé, et les deux autres dans l'ordre inverse.

De préférence encore, chaque séquence comprend un groupe d'opérations répétées identiquement pour chaque ensemble de k cellules, à l'exception éventuellement de petites modifications destinées essentiellement à placer les cellules dans un état attendu déterminé pour les besoins de la séquence suivante.

En principe, le groupe d'opérations commencera toujours par une lecture de l'état des k cellules d'un ensemble de k cellules.

Les valeurs de lecture attendues dans l'opération de lecture de deux des quatre séquences sont en principe complémentaires des valeurs attendues dans les deux autres séquences.

On notera par ailleurs que les deux dernières transitions simultanées d'un ensemble de k cellules se suivent en principe identiquement dans la première et la deuxième séquence; et de même dans la troisième et la quatrième séquence.

Si on veut faire le test de toutes les possibilités d'influence d'un groupe de k-cellules sur une cellule _{Cj} déterminée, il faut que les séquences fassent apparaître successivement tous les ensembles possibles de k cellules.

Mais si on prend en compte la topologie de la mémoire, des simplifications peuvent être réalisées : on considère que seules les cellules les plus proches de la cellule cⱼ, par exemple les cellules éloignées d'au plus deux lignes et deux colonnes de la cellule _{Cj} peuvent véritablement influencer la cellule cⱼ, on limitera les tests d'influence à des opérations d'écriture et lecture sur les ensembles de cellules proches.

Enfin, étant donné que la mémoire est généralement organisée avec entrelaçage de mots et multiplexage des colonnes de cellules vers des plots d'entrée-sortie, ces plots étant en nombre égal au nombre P de bits des mots stockés dans la mémoire, il est tout-à-fait possible de prévoir un test parallèle par mots plutôt qu'un test par cellule. Cela revient à dire que la mémoire est en fait constituée de P mémoires juxtaposées, de N lignes et M colonnes chacune, testées toutes simultanément par le même algorithme.

### CAS D'UNE MEMOIRE BIPORT

La structure préférée de l'algorithme de test selon l'invention pour une mémoire biport est donc une structure à 2 groupes de quatre séquences. Le premier groupe est affecté à la détection de défauts engendrés par deux transitions positives ou deux transitions négatives simultanées; chaque séquence de ce groupe comporte des opérations d'écriture correspondantes. Le deuxième groupe est affecté à la détection de défauts engendrés par une transition positive sur un port simultanée avec une transition négative sur l'autre port; chaque séquence comporte donc aussi des opérations d'écriture correspondantes. Mais il n'y a pas de mélange entre les deux sortes d'opérations : les premières restent réservées au premier groupe et les secondes au second groupe. Chaque séquence comporte l'exécution d'une série de groupes de plusieurs opérations, chaque groupe d'opérations étant effectué sur un couple de cellules de mémoire adressées simultanément l'une par un premier port et l'autre par un second port, et la série étant une série de groupes d'opérations exécutées successivement sur différents couples de cellules.

En principe chaque groupe d'opérations comprend d'abord une lecture de l'état des cellules du couple courant, puis des transitions d'état. En principe également, l'algorithme respectera les caractéristiques suivantes : les deux premières séquences de chaque groupe sont exécutées avec un premier ordre de succession de couples de cellules et les deux autres séquences avec l'ordre inverse; les valeurs de lecture attendues dans l'opération de lecture des première et quatrième séquences de chaque groupe seront complémentaires des valeurs de lecture attendues pour les deuxième et troisième séquences respectivement; et enfin, les deux dernières transitions simultanées du groupe d'opérations de la première et la troisième séquence sont les mêmes que dans la deuxième et la quatrième séquence respectivement.

L'ordre de succession des couples de cellules peut avoir plusieurs configurations.

Dans le cas où on ne tient pas compte de la configuration topologique pratique des cellules de la mémoire et où on considère que chaque cellule peut être influencée par n'importe quelle autre cellule ou couple de cellules de la mémoire, l'ordre de succession préféré est le suivant (pour la moitié des séquences, les autres étant effectuées dans l'ordre inverse) : les cellules sont numérotées de 1 à n et l'ordre de succession des couples est : pour chaque cellule _{Cj} comme premier élément du couple, le deuxième élément du couple prend successivement les valeurs _{Cj+1} à cₙ; puis on passe à la cellule _{Cj+1} comme premier élément du couple et on prend successivement comme deuxième élément les cellules cⱼ₊₂ à cₙ. Les cellules _{Cj} sont prises dans l'ordre de 1 à n.

Mais dans le cas où on tient compte de la topologie physique de la mémoire, l'ordre est le suivant : la succession de couples est une succession de groupes de couples; chaque groupe fait intervenir une même première cellule comme premier élément du couple et un petit nombre de cellules topologiquement voisines de celle-ci comme deuxième élément dur couple, les différents groupes correspondant à des premières cellules différentes.

De préférence, le petit nombre de cellules topologiquement voisines comprend douze cellules écartées de la première cellule d'au plus deux lignes et deux colonnes dans le réseau de cellules constituant la mémoire.

### DESCRIPTION DETAILLEE

D'autres caractéristiques et avantages de l'invention apparaîtront à la lecture de la description détaillée qui suit et qui est faite en référence aux dessins annexés dans lesquels :
- la figure 1 représente sous forme schématique une mémoire biport;
- la figure 2 représente l'organisation interne classique en mots avec entrelaçage et multiplexage;
- la figure 3, divisée pour des raisons d'encombrement en 3a et 3b, représente le tableau des opérations de test selon un exemple du procédé de l'invention;
- la figure 4, divisée en 4a et 4b, représente le tableau des opérations de test dans une variante permettant de détecter des défauts de couplage particuliers;
- la figure 5 représente un groupe de cellules topologiquement juxtaposées, désignées par leur rang de ligne et de colonne;
- la figure 6 représente les 24 cellules placées à une distance maximale de deux lignes et deux colonnes d'une cellule à l'intersection de la ligne p et la colonne q.
- la figure 7 représente un ordre de succession préféré pour le test de couples de cellules faisant intervenir une cellule cp,q,

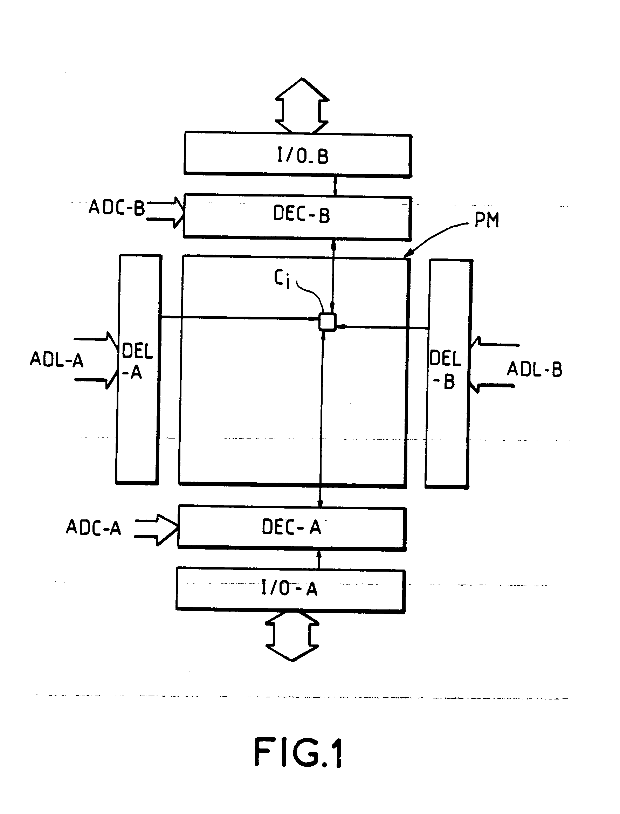

A la figure 1, on a représenté à titre de rappel une mémoire biport. Le réseau de cellules mémoires est désigné par PM; une cellule de mémoire cᵢ de ce réseau est désignée par une adresse de ligne et une adresse de colonne. Mais comme il s'agit d'une mémoire biport, une même cellule cᵢ peut être désignée indépendamment par l'un de deux ports. Le premier port (A) comporte un décodeur de ligne DEL-A, un décodeur de colonne DEC-A pour une mémoire organisée en lignes et colonnes, et un interface d'entrée- sortie de données I/O-A. Le deuxième port (B) comporte un décodeur de ligne DEL-B, un décodeur de colonne DEC-B et un interface d'entrée-sortie de données I/O-B. Une cellule cᵢ peut être adressée par l'ensemble DEL-A DEC-A recevant une adresse de ligne ADL-A et une adresse de colonne ADC-A, et elle est alors reliée à l'interface I/O-A; ou alors les décodeurs du port B peuvent recevoir une adresse de ligne ADL-B et une adresse de colonne ADL-B, auquel cas la cellule est connectée à l'interface I/O-B. Le fonctionnement des deux ports est indépendant, de sorte que deux cellules peuvent être adressées simultanément.

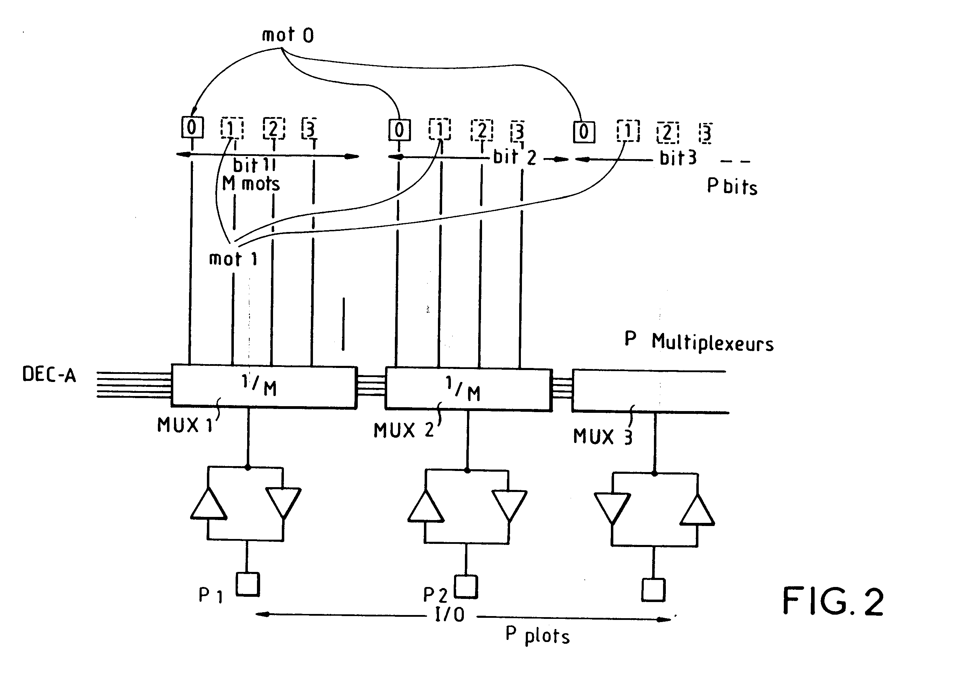

La figure 2 illustre également, à titre de rappel, l'organisation de chaque ligne du réseau PM en M mots de P bits avec entrelaçage, qui permet le test en parallèle sur des mots entiers bien qu'on étudie les influences mutuelles de cellules individuelles les unes sur les autres.

Une seule interface de sortie est représenté. Les MxP lignes de bit (conducteurs en colonne) issues des cellules sont raccordées à des multiplexeurs dé- multiplexeurs 1 parmi M, MUX1, MUX2, etc., permettant de sélectionner, sous la commande du décodeur de colonne, P colonnes représentant un mot parmi M. Ces P colonnes sont alors reliées à P plots d'entrée- sortie P1, P2, ... (il y a P bits dans chaque mot).

Les colonnes de cellules sont groupées par rang de bit et chaque groupe est relié à un des P multiplexeurs. Les bits de rang 1 de tous les mots forment le premier groupe de colonnes juxtaposées (M colonnes); ces colonnes sont reliées à travers le premier multiplexeur MUX1 de M vers 1 au premier plot de données P1. Puis les bits de rang 2, qui forment le deuxième groupe de M colonnes, adjacent au premier groupe, sont reliées par le deuxième multiplexeur de M vers 1 au deuxième plot de données. Et ainsi de suite, il y a P groupes de M colonnes. A l'intérieur d'un groupe de M colonnes, les bits de même rang des M différents mots de la ligne sont juxtaposés. Leur ordre est le même pour tous les groupes de colonnes; sur la figure cet ordre est l'ordre 0, 1, 2, 3, etc. correspondant aux adresses logiques successives des mots, mais ce n'est pas obligatoire.

Avant de décrire en détail l'algorithme préféré selon l'invention, on va donner ci-après quelques explications supplémentaires sur les défauts qu'on cherche à détecter.

### DEFAUTS A DETECTER

Il y a
- des fautes de collage
- des fautes de couplage simple
- et des fautes de couplage complexe

Le collage d'une cellule cᵢ à une valeur q signifie que l'on ne peut pas changer le contenu de cᵢ de q à q^{*} lorsqu'on cherche à écrire dans la cellule cᵢ.

[Note importante : Dans la suite, le complément logique d'une valeur sera noté avec un astérisque : q* est le complément de q]

Ce type de défaut de collage est dû soit à des courants de fuie statique soit à des défauts d'accès au point mémoire.

Parmi les fautes de couplage, il y a :
- les fautes de couplage simple induisant une va- leurfigée : une transition positive (ou négative) d'une cellule cᵢ change l'état d'une cellule cⱼ;
- les fautes de couplage complexes : une transition positive (ou négative) d'une cellule cᵢ combinée avec une transition positive ou négative d'une cellule cᵣ change l'état d'une cellule Cⱼ;

Deux causes principales ont été identifiées à l'origine des fautes de couplage : les courants de fuite et les couplages capacitifs.

Un courant de fuite peut charger ou décharger un noeud d'une cellule cᵢ, et ce courant dépend du champ électrique environnant.

En ce qui concerne les fautes dues à des couplages capacitifs, la transition d'une cellule cⱼ induit une perturbation électromagnétique pouvant modifier in- ductivement la tension sur les noeuds de la cellule cᵢ. Dans ce cas, une transition de sens donné de cⱼ agira toujours dans le même sens. Si le couplage est suffisamment fort (et c'est d'abord une question de proximité des cellules), l'état de la cellule cᵢ peut changer, ou bien la transition de cᵢ peut être empêchée.

### NOTATIONS

Pour noter les couplages entraînant ou n'entraînant pas de défauts, les notations suivantes seront utilisées dans la suite :
Couplage n'entraînant pas de défaut : T[ ]
Couplage entraînant un défaut (indice f) : T_{f}[ ]

on placera entre les crochets deux symboles (lettres affectés d'indices), l'un définissant la transition induisant un couplage et l'autre définissant le résultat sur une cellule cᵢ:

Transition positive (de 0 vers 1) de la cellule _{Cj} : notée j¹
Transition négative (1 vers 0) de la cellule _{Cj} : j^{O}
Résultat = transition positive de la cellule cᵢ : i₁
Résultat = transition négative de la cellule cᵢ : iₒ
Résultat = pas de modification de l'état p de cᵢ: ip
Résultat = pas de modification de l'état p^{*} de cᵢ: i_{P}*

Ainsi, la notation T_{f}[j¹,i₀] représente un couplage apparaissant lors de la transition positive de la cellule _{Cj} et induisant sur la cellule cᵢ une transition négative indésirable.

Ou encore, la notation T[j⁰,iₚ] représente un couplage apparaissant lors de la transition négative de la cellule cⱼ mais n'induisant pas sur la cellule cᵢ de modification de son état p.

Il y a des raisons réalistes de penser que certaines combinaisons de défauts sont très improbables. Par exemple, si une transition j¹ modifie l'état de cᵢ de p à p^{*}, la même transition j¹ ne va sans doute pas modifier l'état de cᵢ de p^{*} à p, car les effets de fuite de courant ou de couplage électromagnétique se produisent dans un seuil sens. Il n'est donc pas réaliste d'envisager qu'il existe simultanément les fautes T_{f}[j¹, i_{o]} et T_{f}[j¹, i_{i]}, ou encore simultanément T_{f}[j⁰,i₀] et T_{f}[j⁰,i₁].

Cette hypothèse est très importante, car elle permet de réduire considérablement la longueur des séquences de test.

Les notations qui précèdent représentent des couplages simples entre deux cellules cⱼ et cᵢ.

Mais dans le cas de mémoires multiports, on a découvert selon l'invention qu'il était possible d'avoir des fautes de couplage complexes.

Par faute de couplage complexe, on entend une faute qui se produit sur la cellule cᵢ par suite de la transition simultanée de cellules cⱼ et cₖ, alors que les transitions individuelles de cⱼ ou cₖ n'entraînent pas nécessairement de défaut.

Le couplage complexe simultané T[j¹, iₚ] + T[k¹, ip] sera noté T[(j¹,k¹),iₚ]; de même, le couplage complexe simultané T[j¹,iₚ] + T[k⁰,iₚ] sera noté T[j¹, k^{O}), ip], etc.. ; et si ces couplages entraînent des défauts, ils sont notés avec l'indice f : T_{f[}...]

Plus généralement, un défaut de couplage simple sera noté T_{f}[(j^{s1},iₚ] et un défaut de couplage complexe sera noté T_{f}[j^{s1},k^{s2}),iₚ], où s1 et s2 appartiennent à l'ensemble {0,1}

Par définition, les défauts de couplage complexe ne peuvent pas être détectés par des opérations d'écriture simples. Ils ne peuvent l'être que par des opérations d'écriture simultanée dans des couples de cellules cⱼ, cₖ et une lecture ultérieure des cellules cᵢ.

Comme dans le cas des couplages simples, on peut admettre que si un couple de transitions des cellules cⱼ et cₖ engendre une transition de p à p^{*} sur cᵢ, alors, ce même couple ne peut pas engendrer une transition de p^{*} à p sur cᵢ.

Enfin, il peut arriver qu'une cellule cᵢ soit perturbée pendant son changement d'état par le changement d'état d'une cellule _{Cj}. Cela est possible dans le cas d'une mémoire multiport puisque deux changements d'état peuvent se produire simultanément. On appellera faute de couplage concurrent ce type de disfonctionnement, par opposition avec les fautes de couplage complexes qui font intervenir trois cellules.

Par analogie avec la notation de couplage complexe T[j^{s1},k^{s2}),iₚ] qui fait intervenir trois cellules cⱼ, cₖ et cᵢ, on notera T[(i^{s1},k^{s2}),iₜₛ₁*] ce type de couplage concurrent, avec l'indice f si un défaut est détecté. L'indice ts1 ^{*} (ou réciproquement ts1) affecté à la lettre i indique que la transition de la cellule cᵢ hors de l'état s1^{*} (ou réciproquements1) est empêchée; la notation is¹ indique qu'on cherche à faire passer la cellule i à l'état s1.

Ce type de défaut provient en pratique du fait qu'une cellule est particulièrement sensible à l'environnement pendant ses transitions d'état.

Là encore, on peut avoir un défaut de couplage concurrent Tf[(i^{s1},k^{s2}),iₜₛ₁*] même si on ne détecte pas de défaut dans le couplage simple T[kS², iₜₛ₁*], c'est-à-dire même s'il n'y a pas d'influence importante de la transition de la cellule cₖ sur la réussite de la transition de la cellule cᵢ.

Le procédé de test qui va être décrit tient compte des défauts de couplage complexe et des défauts de couplage concurrents. Il détecte en outre les défauts de couplage simple.

Pour décrire l'algorithme d'une manière assez détaillée, on prendra d'abord l'exemple d'une mémoire à organisation en bits (et non en mots de plusieurs bits). On transposera ensuite au cas d'une organisation en mots, ce qui ne pose pas de problème dans le cas d'une mémoire organisée comme à la figure 2. D'autre part, on décrira d'abord un algorithme qui ne prend pas en compte la topologie interne de la mémoire, c'est-à-dire qui considère que n'importe quel couple de cellules cⱼ, cₖ peut affecter n'importe quelle cellule cᵢ, quelle que soient les positions respectives de ces cellules. Ensuite on décrira un algorithme qui prend en compte la topologie en considérant que les cellules distantes de plus de deux cellules d'une cellule cᵢ ne peuvent pas influencer la cellule cᵢ.

### ALGORITHME DE TEST

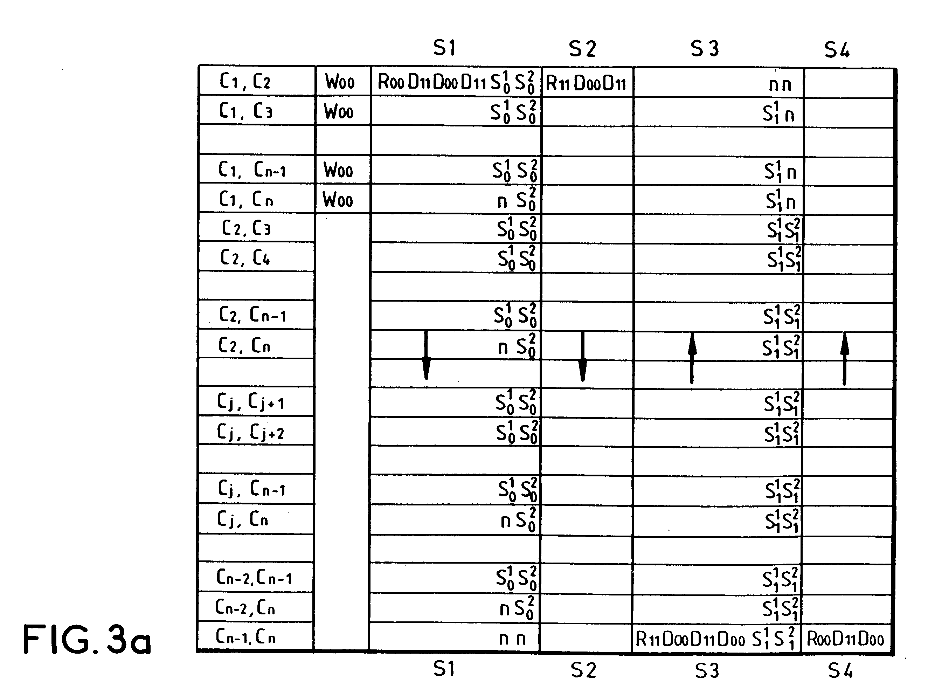

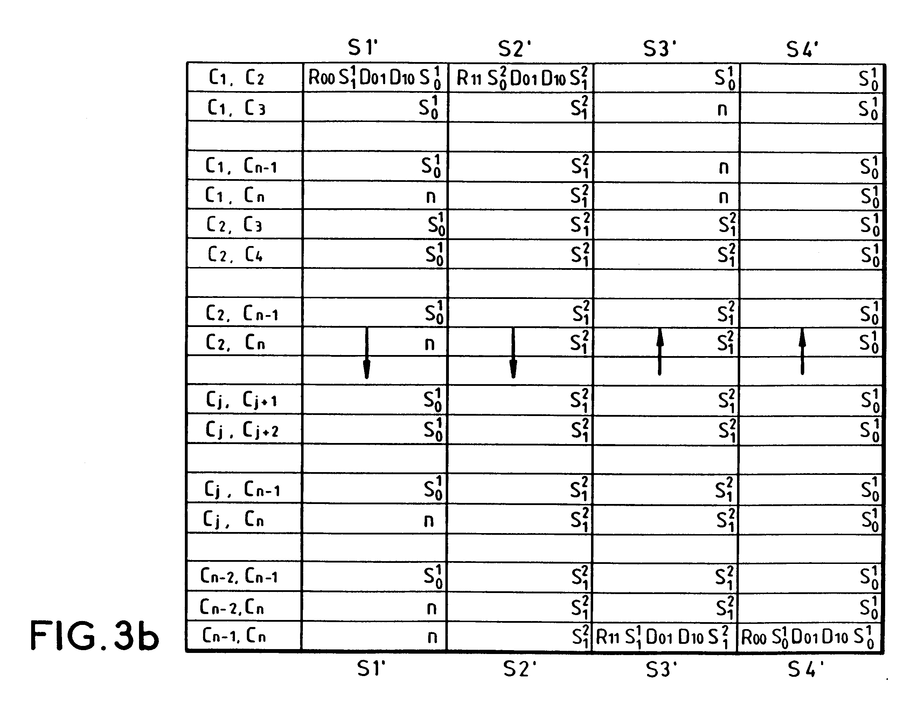

L'algorithme non topologique est décrit en détail dans le tableau de la figure 3. Dans ce tableau, la colonne de gauche représente des couples de cellules sur lesquelles on fait simultanément des opérations d'écriture. La première cellule est écrite à travers le port N°1, et la deuxième à travers le port N°2.

Comme on le voit, tous les couples possibles de cellules sont listés; chaque couple apparaît une fois et une seule.

L'algorithme comporte huit séquences principales, après une séquence d'initialisation. Chaque séquence est caractérisée par un groupe d'opérations particulières, et ce groupe d'opérations est répété successivement pour tous les couples listés. L'ordre dans lequel les couples de cellules sont traités à l'intérieur d'une séquence est également caractéristique de la séquence : pour certaines séquences l'ordre sera celui de la liste; pour d'autres, l'ordre sera l'ordre inverse. Dans le tableau, des flèches noires indiquent cet ordre, à l'intérieur des colonnes représentant les séquences.

Les opérations effectuées sont des opérations de lecture et d'écriture sur un couple de cellules cⱼ,cₖ, opérations qui sont notées comme suit :
- Wₒₒ : initialisation par écriture à l'état 0, 0 d'un couple de cellules cⱼ, cₖ.
- R₀₀ : lecture sur ports 1 et 2, et on s'attend à ce que les résultats soient 0 et 0.
- R₁₁ : lecture sur ports 1 et 2, et on s'attend à ce que les résultats soient 1 et 1.
- Dₒₒ : écriture sur ports 1 et 2 pour aboutir à l'état 0 et 0 (transitions négatives des cellules cⱼ,cₖ).
- D₀₁ : écriture sur ports 1 et 2 pour aboutir à l'état 0 et 1 (transition négative de cⱼ et positive de cₖ).
- D₁₀ : écriture sur ports 1 et 2 pour aboutir à l'état 1 et 0 (transition positive de cⱼ et négative de cₖ).
- D₁₁ : écriture sur ports 1 et 2 pour aboutir à l'état 1 et 1 (transitions positives des cellules cⱼ,cₖ).
- S¹₀ : opération d'écriture simple d'un 0 à partir du port 1 (cellule _{Cj}).
- S²₀ : opération d'écriture simple d'un 0 à partir du port 2 (cellule cₖ).
- S; : opération d'écriture simple d'un 1 à partir du port 1 (cellule _{Cj}).
- S²₁ : opération d'écriture simple d'un 1 à partir du port 2 (cellule cₖ).
- n : pas d'opération.

Dans l'algorithme non topologique, on traite successivement les couples cⱼ, cₖ dans l'ordre suivant :
- pour un cⱼ donné, on prend successivement comme cellules cₖ les cellules cⱼ₊₁ à cₙ;
- et les cⱼ sont pris dans l'ordre de c₁ à cₙ.

Cet ordre sera appelé ordre descendant par rapport au tableau de la figure 3. Il est utilisé pour certaines séquences. L'ordre inverse (ordre descendant) est utilisé pour les autres séquences. Il y a en tout n cellules c₁ à cₙ.

La séquence de départ est une séquence d'initialisation Wₒₒ : mise à l'état zéro de tous les points mé- moir. Bien entendu l'état 0 est choisi arbitrairement; on aurait pu choisir l'état 1 et inverser ensuite tous les indices et exposants dans les opérations effectuées. On peut se contenter d'exécuter l'opération Wₒₒ sur les n-1 premiers couples c₁,c₂ à c₁,cₙ car ensuite toutes les cellules seront à l'état initial.

Les huit séquences de test qui suivent sont divisées en deux groupes de quatre séquences, les groupes étant exécutés sucessivement. Le premier groupe (figure 3a) comprend quatre séquences désignées dans l'ordre par S1, S2, S3, S4; le deuxième groupe (figure 3b) comprend quatre séquences S'1, S'2, S'3, S'4. Chaque séquence de test comprend une série de groupes de plusieurs opérations successives; un groupe d'opérations est exécuté pour un couple de cellules avant de passer au couple suivant; ces opérations consistent d'abord en une lecture de l'état dans lequel sont les cellules du couple suite à la séquence précédente, puis en diverses opérations d'écriture simple (une cellule) ou double (deux cellules). Quand les opérations successives ont été effectuées sur tous les couples de cellules du tableau, on passe à la séquence suivante.

Le groupe d'opérations de la première séquence de test S1 comprend la succession d'opérations suivantes : Rₒₒ, D₁₁, Dₒₒ, D₁₁, S¹₀, S²₀. Ce groupe d'opérations est répété pour les couples de cellules successifs de la liste, dans l'ordre descendant. Toutefois, pour les couples de cellules cⱼ,cₙ, l'opération S¹₀ est remplacée par une absence d'opération (n), de manière que la cellule cⱼ reste finalement programmée à 1 (par D₁₁) avant de passer aux couples cⱼ₊₁,cₖ. Et à la fin de la séquence 1, l'opération S²₀ est également remplacée par un blanc (n) pour que la cellule _{Cn} reste programmée à 1. Ces modifications de certaines opérations au cours de la séquence sont dictées par la nécessité d'avoir toutes les cellules à l'état 1 au début de la séquence suivante S2.

En résumé, la séquence S1 comprend essentiellement une lecture sur les deux ports (Rₒₒ) suivie de trois étapes successives d'écriture double ( sans lecture intermédiaire ) sur les deux ports à la fois (D₁₁, Dₒₒ, D₁₁) suivie enfin de deux opérations d'écriture simple à 0 successivement sur le port 1 et le port 2 (S¹₀, S²₀), en s'arrangeant toutefois pour que la cellule cⱼ adressée par le port 1 soit mise à l'état 1 avant de faire les opérations sur les cellules cⱼ₊₁ et suivantes. Toutes les cellules sont à 1 à la fin de la séquence, sauf défaut.

La deuxième séquence S2 est exécutée dans le même ordre descendant. Les cellules sont donc toutes à l'état 1, s'il n'y a pas de défaut. La séquence comprend trois opérations : lecture (R₁₁) sur les deux ports, écriture simultanée de zéros sur les deux ports (Dₒₒ), écriture simultanée de deux 1 sur les deux ports (D₁₁).

Cette séquence S2 se termine avec des 1 dans toutes les cellules, sauf défaut.

La troisième séquence S3 est partiellement complémentaire de la première : là où il fallait lire ou écrire des zéros, on lit ou écrit des 1, et réciproquement; et de plus, cette troisième séquence est exécutée dans l'ordre ascendant, alors que la première était exécutée dans l'ordre descendant. S3 comprend la succession d'opérations suivantes : R₁₁, Dₒₒ, D₁₁, Dₒₒ, S¦, S2. Ce groupe d'opérations est répété pour les couples de cellules successifs de la liste, dans l'ordre ascendant. Toutefois, pour les couples de cellules _{C1},_{Ck}, à la fin de la séquence, l'opération S²₁ est remplacée par une absence d'opération (n), de manière que la cellule cₖ reste finalement programmée à 0 (par Dₒₒ). Et la toute dernière opération de la séquence S3 est une absence totale d'opération (n,n) sur le couple c₁,c₂, pour que la cellule c₁ aussi reste à zéro. Toutes les cellules sont donc à zéro à la fin de S3, sauf défaut.

La séquence S4 est complémentaire de la séquence S2 : lecture (Rₒₒ) sur les deux ports, écriture simultanée de 1 sur les deux ports (D₁₁), écriture simultanée de deux zéros sur les deux ports (Dₒₒ). L'ordre est ascendant.

Cette séquence S4 se termine avec des 0 dans toutes les cellules, sauf défaut.

La séquence S'1, exécutée dans l'ordre descendant, comprend les étapes suivantes : lecture de zéros sur les deux ports (Rₒₒ); écriture simple d'un 1 sur le port 1 (S¹₁); transition double négative sur le port 1, positive sur le port 2 (D₀₁); transition double positive sur le port 1, négative sur le port 2 (D₁₀); écriture simple d'un 0 sur le port 1 (Sô). Toutefois, la dernière opération (S¹₀) est remplacée par une absence d'opération pour les couples cⱼ, cₙ, pour que les cellules _{Cj} restent programmées à 1 (par Dⱼₒ) avant de passer à l'exécution des opérations sur les couples suivants c_{j+1,}cₙ. La séquence S'1 se termine avec toutes les cellules à 1, sauf défaut.

La séquence S'2 est exécutée dans l'ordre descendant et comprend les opérations de : lecture de 1 sur les deux ports (R₁₁); écriture simple d'un 0 sur le port (S²₀); transition double négative sur le port 1, positive sur le port 2 (D₀₁); transition double, positive sur le port 1, négative sur le port 2 (D₁₀); écriture simple d'un 1 sur le port 2 (S²₁). La séquence S'2 se termine avec toutes les cellules à 1, sauf défaut.

La séquence S'3 est exécutée dans l'ordre ascendant et comprend les opérations de : lecture de 1 sur les deux ports (R₁₁); écriture simple d'un 1 sur le port 1 (S¹₁); transition double négative sur le port 1, positive sur le port 2 (D₀₁); transition double, positive sur le port 1, négative sur le port 2 (D₁₀); écriture simple d'un 1 sur le port 2 (S²₁). Toutefois, pour les couples c₁, cₖ (sauf le couple c₁,c₂) l'opération S²₁ est remplacée par une absence d'opération (n) pour que les cellules _{Cn} à c₃ restent dans l'état 0 (par Dⱼₒ) à la fin de la séquence ; et pour le couple c₁,c₂, elle est remplacée par l'opération S¹₀ (écriture d'un 0 dans c₁), afin que non seulement la cellule _{C2} reste à 0 (par Dⱼₒ) mais aussi la cellule c₁ soit mise à 0. La séquence S'3 se termine donc avec toutes les cellules à 0, sauf défaut.

Enfin, la séquence S'4, exécutée clans l'ordre ascendant, comporte : la lecture Rₒₒ, l'écriture simple d'un 0 sur le port 1 (S¹₀); la transition double mixte, négative sur le port 1, positive sur le port 2 (D₀₁); la transition double mixte, positive sur le port 1, négative sur le port 2 (D₁₀); et à nouveau l'écriture simple d'un 0 sur le port 1 (S¹₀).

En résumé, on voit que l'algorithme de test de la figure 3 comporte deux groupes de séquences : S1 à S4 d'une part, S'1 à S'4 d'autre part, destinés à détecter chacun les défauts dus à un type de transition particulier. Le groupe S1 à S4 est destiné à détecter les défauts dus aux transitions doubles négatives D₀₀ et aux transitions doubles positives D₁₁; et pour cela, chaque couple de cellules subit au moins une fois la transition D₀₀ et la transition complémentaire D₁₁ dans chacune des séquences S1 à S4; mais les couples de cellules ne subissent pas d'autres transitions telles que D₀₁ ou D₁₀ qui risqueraient de masquer les effets des premières. Réciproquement, le groupe S'1 à S'4 est destiné à détecter les défauts dus aux transitions doubles mixtes D₀₁ et aux transitions complémentaires D₁₀; et pour cela, chaque couple de cellules subit au moins une fois la transition D₀₁ et la transition complémentaire D₁₀ dans chacune des séquences S'1 à S'4; et ils ne subissent pas les transitions Dₒₒ ou D₁₁.

De plus, deux des séquences de chaque groupe sont parcourues dans un sens (descendant pour S1, S2, S'1, S'2) et les deux autres dans le sens inverse (ascendant pour S3, S4, S'3, S'4). Chaque groupe d'opérations commence par une lecture (Rₒₒ ou R₁₁) de l'état des deux cellules du couple concerné, ceci quelle que soit la séquence. Les valeurs de lecture attendues dans l'opération de lecture des première et quatrième séquences (0, 0) d'un groupe de séquences sont complémentaires des valeurs attendues (1, 1 ) dans l'opération de lecture des deuxième et troisième séquences.

Enfin, les deux dernières transitions doubles du groupe d'opérations des première et troisième séquences sont les mêmes que dans la deuxième et la quatrième séquence respectivement : D₀₀D₁₁ dans S1 comme dans S2; D₁₁D₀₀ dans S3 comme dans S4; D₀₁D₁₀ dans S'1 comme dans S'2; et encore D₀₁D₁₀ dans S'3 comme dans S'4 (on aurait pu envisager D₁₀D₀₁ dans S'4). dans S'4).

Finalement, on notera que les séquences S1 et S2 doivent rester juxtaposées dans cet ordre; de même S3 et S4, S'1 et S'2, S'3 et S'4. Mais à l'intérieur d'un groupe de séquences, par exemple S1 à S4, on peut intervertir l'ordre d'exécution des sous- groupes de deux séquences; par exemple le sous-groupe S3,S4 peut être exécuté avant le sous-groupe S1,S2. Il faut cependant alors en tenir compte au moment de l'initialisation, pour initialiser à 1 plutôt qu'à zéro toutes les cellules. Et d'autre part il faut alors faire la même interversion dans l'autre groupe S'1 à S'4.

### APTITUDE DE L'ALOGRITHME A LA DETECTION DES DEFAUTS

Pour montrer l'aptitude de cet algorithme à détecter les fautes de couplage complexe, on va donner ci-après quelques explications complémentaires.

Si les fautes de couplage complexe résultent de transitions Dₒₒ ou D₁₁, elles sont détectées par les séquences S1 à S4. Les fautes ne sont alors pas masquées par les transitions D₀₁ ou D₁₀ puisque ces transitions ne sont pas présentes dans les séquences S1 à S4. Si au contraire les défauts résultent de transitions D₀₁ ou Dₒᵢ, elles seront détectées par les séquences S'1 à S'4. C'est la raison pour laquelle l'algorithme est divisé en groupes de séquences distincts affectés chacun à la détection d'un type de faute de couplage complexe bien déterminé. Le premier groupe est affecté aux fautes dues à des transitions doubles négatives et positives (D₀₀ et D₁₁). Le deuxième groupe est affecté aux transitions mixtes D₀₁ et Dio.

Supposons qu'il existe un défaut T_{f}[(j^{s1},i^{s2}),k_{P}], où s1 et s2 sont identiques (0 ou 1). Cela veut dire que la cellule cₖ est affectée par des transitions simultanées de même sens sur les cellules _{Cj} et cᵢ.

Supposons que i < j (hypothèse sans aucune incidence sur la suite vu le rôle symétrique des indices j et i dans les défauts sur la cellule d'indice k).

Si de plus i < k, on peut montrer que le défaut de couplage ci-dessus T_{f}[(j^{s1} ,i^{s2}),kₚ] est détecté obligatoirement par la séquence S1 ou S2. Et inversement, si i > k, le défaut sera obligatoirement détecté par la séquence S3 ou la séquence S4.

Symétriquement on peut montrer que si s1 et s2 sont complémentaires (0 et 1 ou 1 et 0), c'est-à-dire si le défaut implique une transition D₀₁ ou Dᵢₒ, alors le défaut T_{f}[j^{s1},i^{s2}),kₚ] est détecté obligatoirement soit par l'une des séquences S'1, S'2 soit par l'une des séquences S'3, S'4.

A titre d'exemple, on peut donner la démonstration pour les fautes provoquées par des transitions Dₒₒ ou D₀₁ et dans le cas i < j:
a) si i < k et j < k , alors le couple cᵢ,cⱼ est situé après le couple cᵢ₋₁,cₖ et avant le couple cᵢ,cₖ dans la séquence descendante.
   - s'il y a plusieurs cellules cⱼ entraînant une faute T_{f}[j⁰,i⁰),kₚ] ou T_{f}[j¹,i¹),kₚ], on considère que l'indice j est l'indice de la dernière cellule entraînant une telle faute sur cₖ.
   - après l'opération S²₀ effectuée sur le couple c_{i-1,}cₖ dans S1, la cellule cₖ doit être à 0; inversement, après l'opération D₁₁ dans la séquence S2, elle doit être à 1 ;
   - si cₖ est affectée au moins par le défaut T_{f}[j¹,i¹),kₚ], elle prend la valeur erronnée 1 après la transition D₁₁ appliquée à cᵢ,cⱼ dans la séquence S1, ou alors elle prend la valeur erronnée 0 après cette même transition dans la séquence S2;
- ensuite, que ce soit dans S1 ou dans S2, il n'y a plus d'autre transition risquant de modifier cₖ avant la prochaine lecture Rₒₒ (dans S1) ou R₁₁ (dans S2) du couple cᵢ,cₖ (postérieure aux opérations sur cᵢ,cⱼ) dans la même séquence; si le défaut se produit pendant S1, on va donc lire cₖ = 1 alors qu'on attend 0; le défaut est détecté à ce stade de la séquence S1; ou alors, si le défaut se produit pendant S2, on va lire cₖ = 0 alors qu'on attend 1; le défaut est détecté à ce stade de S2;
- si cₖ n'est affectée au contraire que par le défaut T_{f}[(j⁰,i⁰),kₚ] sans être affectée par le défaut T_{f}[(j¹,i¹),kₚ], cₖ prend la valeur erronée 1 dans la séquence S1 après la transition D₀₀ portant sur le couple cᵢ,cⱼ mais ne change pas au moment de D₁₁; ou alors, cₖ prend la valeur erronée 0 pendant la même transition de la séquence S2 et ne change pas au moment de D₁₁; ensuite, dans les deux cas, il n'y a plus de transition susceptible d'affecter cₖ avant la lecture Rₒₒ ou R₁₁ du couple cᵢ,cₖ dans la suite de la séquence; là encore on va lire 1 alors qu'on attend 0 dans la séquence S1, ou lire 0 alors qu'on attend 1 dans la séquence S2; l'erreur est détectée à ce stade de la séquence S1 ou S2;
   b) si i < ketj > k, alors le couple cᵢ,cⱼ est situé après le couple cᵢ,cₖ et avant le couple cᵢ₊₁,cₖ dans la séquence descendante. Le raisonnement est le même, en remplaçant simplement le couple cᵢ₋₁,cₖ par le couple cᵢ,cₖ et le couple cᵢ,cₖ par cᵢ₊₁,cₖ. En résumé, l'initialisation correcte de la cellule cₖ a lieu lors de l'écriture du couple cᵢ, cₖ et non cᵢ₋₁,cₖ; la faute se produit pendant la transition du couple cᵢ,cⱼ; et la détection de la faute se produit pendant la lecture du couple cᵢ₊₁,cₖ et non cᵢ,cₖ.
   c) si i > k, alors le couple cᵢ,cⱼ est situé après les couples faisant intervenir les cellules cₖ, dans les séquences descendantes; les défauts ne peuvent être détectés que par une séquence ascendante S3 ou S4.

En suivant la même démarche qui au paragraphe a ci-dessus, on aboutit immédiatement à la conclusion que les défauts T_{f}[(j⁰, i°),kp] et T_{f}[j¹,i¹),kₚ] sont détectés au cours des séquences S3 et S4 selon le sens du défaut (passage de cₖ à 0 ou à 1) : l'initialisation d'une cellule est faite a priori à 1 avant une séquence S3; si au cours de la transition D₁₁ ou Dₒₒ de cᵢ,cⱼ pendant S3 la cellule cₖ bascule à 0, ce basculement sera détecté dans la même séquence lors d'une lecture R₁₁ de la cellule cₖ,cₙ (premier couple rencontré faisant intervenir cₖ); ou alors, l'initalisation à 0 est faite pendant S3; et si au cours des transitions Dₒₒ ou D₁₁ de S4 sur le couple cᵢ,cⱼ la cellule cₖ bascule à 1, ce basculement sera détecté un peu plus loin dans la même séquence au moment de la lecture Rₒₒ de cₖ, cₙ.

Enfin, comme on l'a dit, un raisonnement similaire peut être fait à propos des défauts dus aux transitions D₀₁ et D₁₀; ces défauts sont détectés dans les séquences S'1 à S'4 . Là encore, des défauts dus aux transitions D₀₀ et D₁₁ ne peuvent être masqués au cours de ce test puisque les séquences S'1 à S'4 ne font pas intervenir de telles transitions.

### FAUTES DE COUPLAGE CONCURRENT ET FAUTES DE COLLAGE

Il peut arriver qu'il y ait simultanément un défaut de collage : cᵢ ne peut sortir de l'état s1 ou s1^{*} et un défaut de couplage concurrent : T_{f}[(i^{s1},j^{s2}, i_{ts1*}] sur cᵢ₋ Selon que les défauts agissent dans le même sens ou non, les effets seront différents; si les défauts agissent en sens contraire, l'un d'eux aura une influence prépondérante et sera appelé "dominant".

On peut montrer que l'algorithme du tableau de la figure 3 détecte les défauts de collage ou les défauts de collage dominants par rapport aux défauts de couplage concurrent : la séquence S2 permet, grâce à la succession Dₒₒ, D₁₁ (pour un couple faisant intervenir c_{;}), et R₁₁ (pour un couple suivant faisant encore intervenircᵢ) de détecter les défauts de collage, même en présence d'un défaut de couplage concurrent, pourvu que le collage soit dominant. Lorsque ci = Cₙ-₁ ou cᵢ = _{Cn} on peut également trouver, dans S2 ou S3 des successions qui fournissent la même possibilité de détection.

Mais le tableau de la figure 3 ne permet pas de détecter correctement des défauts de collage simultanés avec des défauts de couplage concurrent lorsque ces derniers sont dominants par rapport aux défauts de collage.

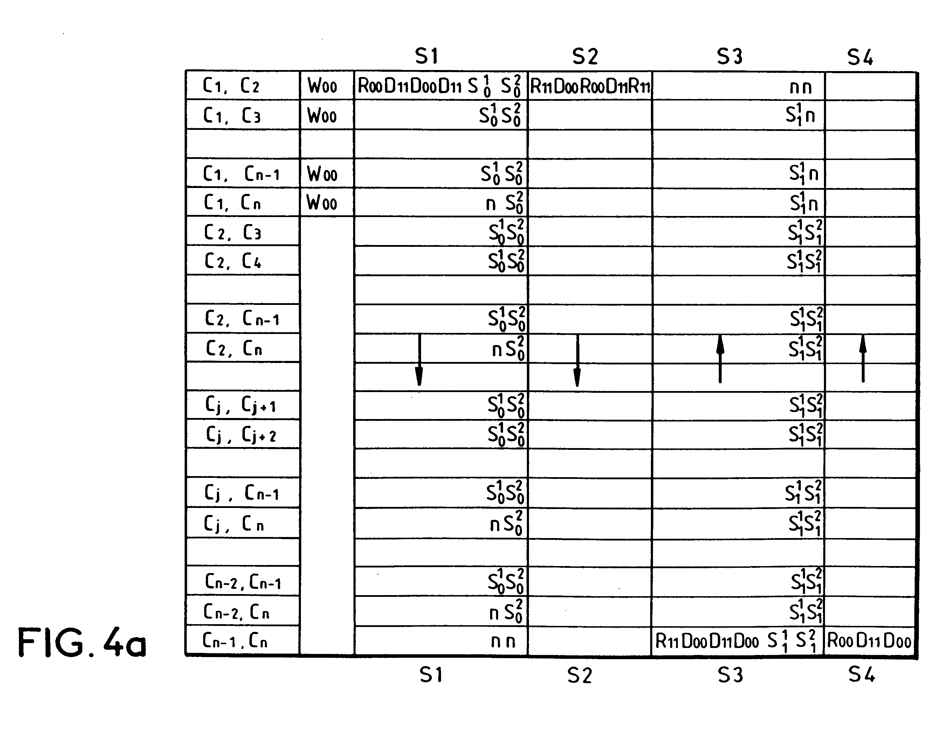

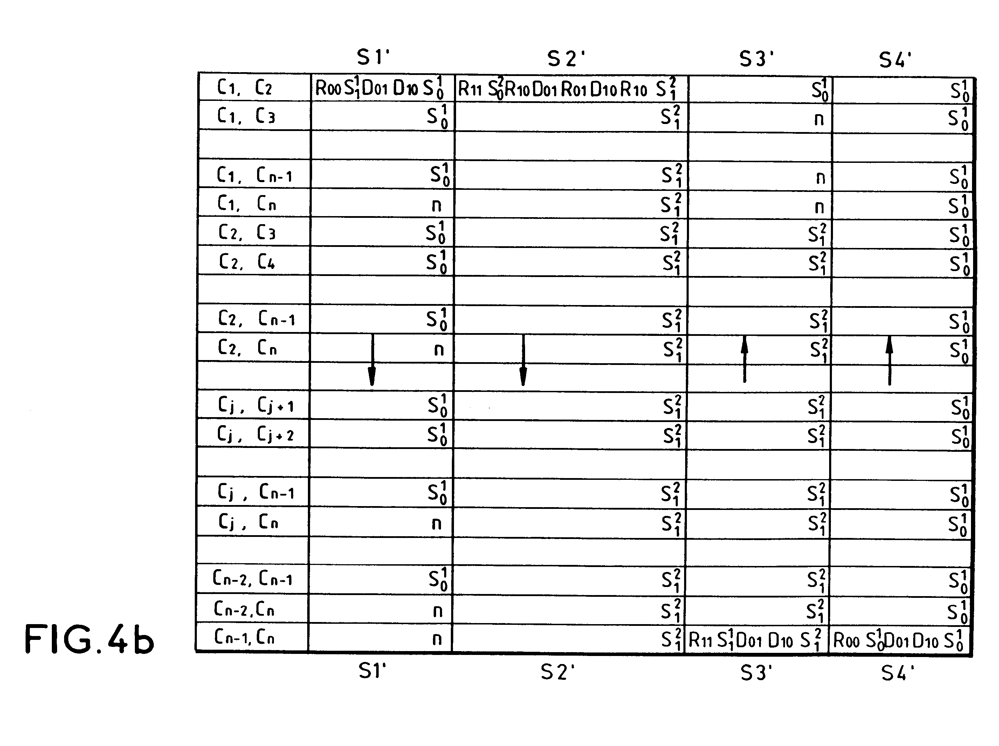

L'algorithme du tableau de la figure 4 (figure 4a et 4b) permet cependant de résoudre le problème.

L'algorithme modifié comprend, dans la séquence S2, l'opération de lecture Rₒₒ insérée entre D₀₀ et D₁₁, et l'opération R₁₁ après D₁₁. De plus, dans la séquence S'2, il comprend l'opération R₁₀ entre S²₀ et D₀₁, l'opération Rₒ₁ entre D₀₁ et D₁₀, et l'opération R₁₀ à nouveau entre D₁₀ et S²₁. Toutes ces lectures supplémentaires sont effectuées après des tentatives d'écriture dans un couple de cellules; par conséquent, les fautes de couplage concurrent dominantes (qui empêchent une écriture souhaitée) seront obligatoirement détectées.

En résumé, on peut vérifier que l'algorithme du tableau de la figure 4 est même plus général encore car il détecte non seulement les défauts de couplage complexe, les défauts de couplage concurrent, les défauts de collage, dominants ou non, mais aussi les défauts de couplage simple si on fait l'hypothèse assez raisonnable que deux transitions de sens opposé d'une cellule _{Cj} n'ont pas le même effet sur une cellule Cₖ.

Par ailleurs, il faut noter que l'algorithme ne détectera pas tous les défauts complexes pouvant être entraînés par des transitions simultanées sur c₁ et cₙ. Le cas serait assez exceptionnel compte tenu de l'éloignement de ces cellules qui sont a priori aux deux extrémités de la mémoire, pour qu'il ne justifie pas de compliquer l'algorithme.

### APPROCHE TOPOLOGIQUE

Le test complet d'une mémoire dont le nombre n de cellules est élevé peut prendre beaucoup de temps (le nombre d'opérations de test est proportionnel au carré de n).

En pratique, les défauts de couplage ne se produisent qu'entre cellules suffisamment voisines topologiquement les unes des autres. Une manière de réduire le nombre de séquences de test consiste à ne chercher à détecter que des défauts de couplage entre un petit nombre de cellules voisines les unes des autres. Dans ce cas, le nombre d'opérations de test peut devenir proportionnel à n, ce qui est très avantageux pour des mémoires de grande capacité.

On utilise d'abord le fait que l'organisation habituelle des mémoires est une organisation en lignes de M mots de P bits, avec un entrelaçage des mots et un multiplexage des colonnes de la mémoire vers les ports d'entrée-sortie : deux cellules voisines n'appartiennent jamais à un même mot. Les colonnes sont agencées de la manière suivante : les bits de rang 1 des M mots sont juxtaposés (d'ailleurs dans un ordre physique qui est souvent différent de l'ordre logique des adresses des mots) et sont multiplexés pour sortir sur un même plot d'entrée-sortie qui est le plot de rang 1; les bits de rang 2, juxtaposés, forment un groupe similaire, à côté du premier, et sont multiplexés sur un deuxième plot, etc. C'est ce qui a été rappelé en référence à la figure 2.

Cette organisation habituelle fait qu'on peut tester la mémoire avec les algorithmes des tableaux des figures 3 et 4, tout en adressant la mémoire par mots et non par cellules. Les défauts seront détectés dans les mots. Le test est donc parallélisé par mots. Les opérations de lecture, écriture des tableaux sont des opérations effectuées sur les mots, et les couples de cellules sur lesquelles on effectue ces opérations sont en fait des couples de mots d'adresse différente. Pour une mémoire de N lignes de M mots de P bits, cela revient à faire un test sur une mémoire de N x P cellules (et parallèlement avec M-1 autres mémoires de N x P cellules chacune).

De plus, supposons qu'une cellule soit alors repérée par son adresse de ligne retson adresse de colonne c (ou adresse de mot dans la ligne) : c_{r,c}.

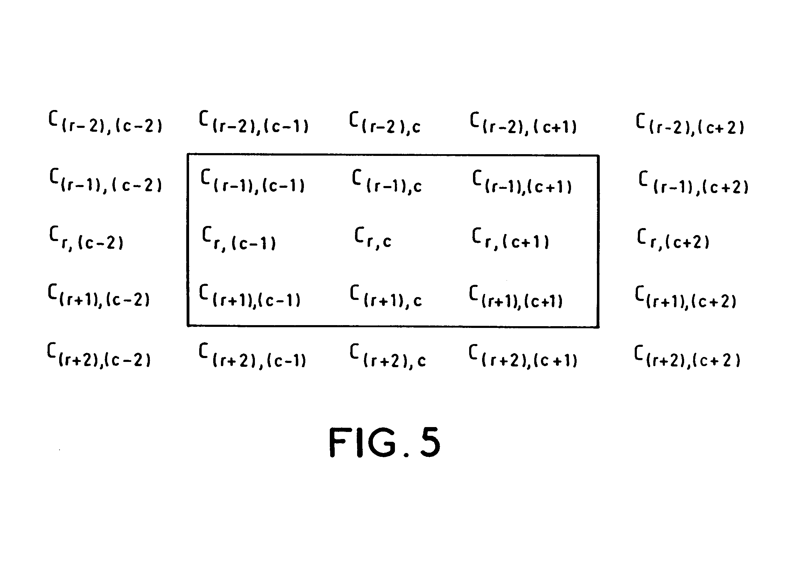

Il y a en tout huit cellules adjacentes qui entourent cette cellule c_{r,c}. La figure 5 représente ces cellules qui sont dans les lignes r, r-1 et r+1 et dans les colonnes c, c-1 et c+1.

Si on ne teste que les défauts engendrés dans cette cellule c_{r,c} par les cellules immédiatement adjacentes, on peut alors dire que les couples qui risquent d'influencer une cellule crc sont des couples de cellules distants entre eux d'au plus deux lignes et d'au plus deux colonnes. Cela signifie qu'on peut utiliser l'algorithme de test en effectuant des opérations uniquement sur des groupes de cellules ayant cette propriété si on ne désire pas tester d'autres influences plus éloignées.

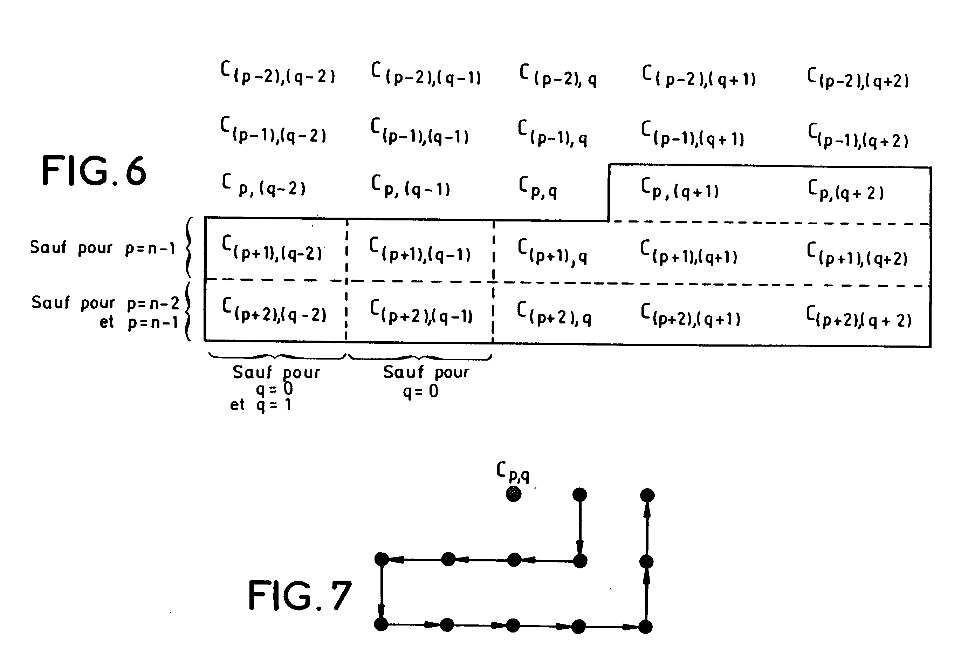

Si on regarde la figure 6 et si on prend une cellule quelconque _{C}p,q d'adresse de ligne p et d'adresse de colonne q, on constate qu'il y a 24 cellules distantes de cette cellule d'au plus deux lignes et deux colonnes.

Il est par conséquent inutile d'effectuer l'algorithme sur tous les couples de cellules possibles de la mémoire; il suffit, pour chaque cellule, de considérer ses 24 voisines les plus proches. En réalité même, il suffit de prendre la moitié, soit 12 cellules pour des raisons de symétrie, car si on en prenait 24 elles seraient testées deux fois de suite. On effectuera donc les opérations de lecture et d'écriture des tableaux des figures 3 ou 4 non pas sur tous les couples de cellules possibles mais uniquement sur des couples de cellules cᵢ,cⱼ dans lesquels cᵢ est une cellule _{C}p,q quelconque (figure 6) et _{Cj} est une des douze cellules voisines de la cellule _{C}p,q, encadrées sur la figure 6. Pour des raisons évidentes, lorsque _{C}p,q est proche des bords de la mémoire, il y aura moins de douze cellules voisines.

Par conséquent, les séquences S1 à S4 et S'1 à S'4 font intervenir successivement les couples suivants, organisés en groupes successifs de douze couples ayant tous une même première cellule _{C}p,q :
- premier couple : la cellule _{C}p,q, et une première des douze cellules qui la suivent dans l'ordre des lignes et des colonnes et qui sont éloignées de _{C}p,q d'au plus deux lignes et deux colonnes;
- deuxième couple : c_{p,q} et une autre de ces douze cellules,
- etc. jusqu'à la douzième cellule

Puis on passe à un autre groupe de douze couples faisant intervenir comme première cellule c_{p,q+1}, etc.

Comme première cellule c_{p,q} du couple on prendra successivement toutes les cellules de la mémoire, en principe dans l'ordre des colonnes à l'intérieur d'une même ligne, et dans l'ordre successif des lignes. On commencera donc par une cellule c_{1,1} pour terminer par une cellule c_{N},_{M} s'il y a N lignes et M colonnes, et à chaque fois douze couples successifs sont considérés, sauf pour les bords de la mémoire.

Les douze cellules considérées dans chaque groupe sont les douze cellules suivantes les plus proches topologiquement, mais on aurait aussi pu considérer les douze précédentes, voire même d'autres groupes de douze cellules parmi les plus proches topologiquement.

Pour des raisons d'implémentation dans le circuit intégré lorsque le circuit de test est en partie formé dans le circuit intégré, on a avantage à simplifier au maximum les séquenceurs qui définissent l'ordre de succession des couples de cellules étudiés.

La figure 7, qui correspond à la figure 6 et qui représente les douze cellules proches qui suivent une cellule déterminée, montre un exemple d'ordre de succession des cellules dans un groupe de douze. Dans ce type de succession, on incrémente ou décré- mente d'une unité seulement soit la ligne soit la colonne. D'autres exemples sont possibles avec cette même propriété. Le séquencement est alors possible avec un circuit très simple.

### GENERALISATION A DES MEMOIRES MULTIPORTS

Les algorithmes décrits sont généralisables à des mémoires à trois ou quatre ports ou plus. Il peut en effet y avoir des défauts de couplage complexes d'ordre k dus à des transitions simultanées sur k ports.

Ce ne sont donc pas des couples de cellules qui subissent un algorithme de test mais des triplets, des quadruplets, ou plus généralement des k-tuples pour des mémoires à k ports.

Il y aura alors 2^{k-1} groupes de 4 séquences, chaque groupe étant affecté à la détection de défauts engendrés par une configuration déterminée de k transitions et par la configuration de k transitions complémentaires (par exemple deux transitions positives pour les deux premières cellules et une transition négative pour les autres) et à la configuration complémentaire de k transitions iverses des premières (deux transitions négatives pour les premières cellules, une transition positive pour les autres). Toutes les configurations de transitions simultanées possibles doivent être représentées si on veut détecter leur effet. Une seule configuration (avec la configuration complémentaire) est utilisée dans chaque groupe de séquences, et cette configuration (avec la configuration complémentaire) apparaît dans chacune des quatre séquences du groupe.

Deux des quatre séquences sont en principe parcourues dans un certain ordre de k-tuples de cellules, les deux autres dans l'ordre inverse.

Si on considère des couplages complexes d'ordre k, il faut tester l'influence de transitions simultanées de k cellules. Il y a 2^{k} types de transitions possibles de cette sorte, qui peuvent être groupées en sous ensembles de 2^{k-1} tels que chaque ensemble inclut une transition dans un sens D_{i1i2...ik} et une transition opposée Dᵢ₁*ᵢ₂*_{...ik}*. Par analogie avec les mémoires biport, Dᵢ₁ᵢ₂ correspond à D₀₀ ou Dₒᵢ ; Dᵢ₁*ᵢ₂* serait D₁₁ et Dᵢₒ. Pour chacun de ces couples de transitions opposées (disons t; ,t2 , où i varie entre 1 et 2^{k-1}) on générera quatre séquences S₁ⁱ, S₂ⁱ, S₃ⁱ, S₄ⁱ. Les deux premières adressent les k-tuples (couples, triplets, quadruplets, etc..) de cellules dans un ordre descendant, et les deux autres dans un ordre ascendant.

Dans chaque séquence et pour chaque k-tuple, on effectue d'abord une opération de lecture simultanée des k cellules du k-tuple. Puis on effectue certaines transitions. Pour les transitions simultanées de k cellules, on effectue les transitions tⁱ₁ ,tⁱ₂. Et chacune de ces transitions doit être effectuée au moins une fois dans chacune de ces quatre séquences.

Pour chaque k-tuple les deux dernières transitions de la séquence S₁ⁱ doivent être les mêmes que dans la séquence S₂ⁱ (c'est-à-dire t; suivi par t₂ⁱ, ou le contraire, dans les deux séquences). C'est la même chose pour les séquences S₃ⁱ et S₄ⁱ. Egalement, lorsqu'on effectue la première opération de chaque k-tuple (lecture simultanée des k cellules), les valeurs attendues dans la séquence S₁ⁱ doivent être complémentaires des valeurs attendues dans la séquence S₂ⁱ. Idem pour S₃ⁱ et S₄ⁱ.

## Revendications

1. Procédé de test de mémoires multiports, caractérisé en ce qu'il comporte des opérations d'écriture simultanée dans plusieurs cellules de mémoire par les différents ports de la mémoire, pour détecter des défauts de couplage qui perturbent le fontionnement d'une cellule _{Cj} de la mémoire lors de l'accès simultané à plusieurs cellules de la mémoire par les différents ports, même lorsque la cellule _{Cj} n'est pas perturbée par un accès individuel à ces cellules.

2. Procédé selon la revendication 1, pour le test d'une mémoire à k ports (k>1), caractérisé en ce qu'il comporte 2^{k-1} groupes de quatre séquences de test, chaque groupe étant affecté à la détection de défauts engendrés par une configuration déterminée de k transitions simultanées et par la configuration complémentaire de k transitions inverses des premières, chacune des quatre séquences du groupe comportant à cet effet des opérations d'écriture simultanée correspondant à cette configuration et à la configuration complémentaire, toutes les configurations de transitions dont on veut détecter les effets étant représentées dans les 2^{k-1} groupes et une seule de ces configurations étant utilisée, avec la configuration complémentaire, dans chaque groupe de quatre séquences, les opérations d'écriture étant effectuées à chaque fois sur un ensemble déterminé de k cellules et chaque séquence comportant des opérations sensiblement identiques effectuées sur une succession déterminée d'ensembles de k cellules.

3. Procédé selon la revendication 2, caractérisé en ce que parmi les quatre séquences d'un groupe de séquences, il y en a deux (S1, S2; ou S'1, S'2) qui sont effectuées sur la dite succession d'ensembles dans un ordre déterminé, et les deux autres (S3, S4; ou S'3, S'4) dans l'ordre inverse.

4. Procédé selon l'une des revendications 2 et 3, caractérisé en ce que chaque séquence comprend un groupe d'opérations répétées identiquement pour chaque ensemble de k cellules, à l'exception éventuellement de petites modifications destinées essentiellement à placer les cellules dans un état attendu déterminé pour les besoins de la séquence suivante.

5. Procédé selon la revendication 4, caractérisé en ce que le groupe d'opérations commençe par une lecture de l'état des k cellules d'un ensemble de k cellules.

6. Procédé selon la revendication 5, caractérisé en ce que les valeurs de lecture attendues dans l'opération de lecture de deux des quatre séquences sont complémentaires des valeurs attendues dans les deux autres séquences.

7. Procédé selon l'une des revendications 2 à 6, caractérisé en ce que les deux dernières transitions simultanées d'un ensemble de k cellules se suivent identiquement dans la première et la deuxième séquences, et de même dans la troisième et la quatrième séquences.

8. Procédé selon l'une des revendications 2 à 8, caractérisé en ce que la succession d'ensembles de k cellules se décompose en sous groupe d'ensembles de k-cellules comprenant une cellule _{Cj} et des cellules éloignées de la cellule _{Cj} d'au plus deux lignes et deux colonnes, chaque sous-groupe correspondant à une cellule cⱼ différente de la cellule cⱼ des autres sous groupes.

9. Procédé selon l'une des revendications 1 à 8, caractérisé en ce que le test est effectué en parallèle par mots, l'algorithme de test étant effectuée simultanément sur toutes les cellules d'un mot.

10. Procédé de test d'une mémoire biport, caractérisé en ce qu'il comporte des opérations d'écriture simultanée dans deux cellules de mémoire cᵢ et cₖ par les deux ports de la mémoire, pour détecter des défauts de couplage qui perturbent le fontionnement d'une cellule _{Cj} de la mémoire lors de l'accès simultané à une cellule cᵢ par un des ports et à une cellule _{Cj} par l'autre port, même lorsque la cellule _{Cj} n'est pas perturbée par un accès individuel à la cellule cᵢ ou à la cellule cₖ.

11. Procédé de test selon la revendication 10, caractérisé en ce qu'on exécute successivement deux groupes de quatre séquences de test (S1,S2,S3,S4 ; S'1,S'2,S'3,S'4) , le premier groupe étant affecté à la détection de défauts engendrés par deux transitions positives ou deux transitions négatives simultanées et chaque séquence de ce groupe comportant des opérations d'écriture correspondantes (D₁₁, Dₒₒ); le deuxième groupe étant affecté à la détection de défauts engendrés par une transition positive sur un port simultanée avec une transition négative sur l'autre port et chaque séquence comportant donc aussi des opérations d'écriture correspondantes (D₁₀, Dₒᵢ), chaque séquence comportant l'exécution d'une série de groupes de plusieurs opérations, chaque groupe d'opérations étant effectué sur un couple de cellules de mémoire adressées simultanément l'une par un premier port et l'autre par un second port, et la série étant une série de groupes d'opérations exécutées successivement sur différents couples de cellules.

12. Procédé selon la revendication 11, caractérisé en ce que chaque groupe d'opérations comprend d'abord une lecture (Rₒₒ, R₁₁) de l'état des cellules du couple courant, puis des transitions d'état.

13. Procédé selon la revendication 12, caractérisé en ce que les valeurs de lecture attendues dans l'opération de lecture des première et quatrième séquences de chaque groupe sont complémentaires des valeurs de lecture attendues pour les deuxième et troisième séquences respectivement.

14. Procédé selon l'une des revendications 11 à 13, caractérisé en ce que les deux premières séquences de chaque groupe sont exécutées avec un premier ordre de succession de couples de cellules et les deux autres séquences avec l'ordre inverse.

15. Procédé selon l'une des revendications 11 à 14, caractérisé en ce que les deux dernières transitions simultanées du groupe d'opérations de la première et la deuxième séquence sont les mêmes que dans la troisième et la quatrième séquence respectivement.

16. Procédé selon l'une des revendications 11 à 15, caractérisé en ce que l'ordre de succession des couples de cellules dans une séquence est le suivant : les cellules sont numérotées de 1 à n et l'ordre de succession des couples est : pour chaque cellule _{Cj} comme premier élément du couple, le deuxième élément du couple prend successivement les valeurs cⱼ₊₁ à cₙ; puis on passe à la cellule cⱼ₊₁ comme premier élément du couple et on prend successivement comme deuxième élément les cellules cⱼ₊₂ à cₙ; les cellules cⱼ sont prises dans l'ordre de 1 à n.

17. Procédé selon l'une des revendications 1 à 15, caractérisé en ce que l'ordre de succession des couples de cellules dans une séquence est le suivant : la succession de couples est une succession de groupes de couples; chaque groupe fait intervenir une même première cellule comme premier élément du couple et un petit nombre de cellules topologiquement voisines de celle-ci comme deuxième élément du couple, les différents groupes correspondant à des premières cellules différentes.

18. Procédé selon la revendication 17, caractérisé en ce que le petit nombre de cellules topologiquement voisines comprend douze cellules écartées de la première cellule d'au plus deux lignes et deux colonnes.
